# EUROPÄISCHE PATENTANMELDUNG

(11) **EP 0 834 595 A1**
(43) Veröffentlichungstag der Anmeldung: **08.04.1998**
(21) Anmeldenummer: 97114883.8
(22) Anmeldetag: 28.08.1997
(51) Int. Cl.: C23C 14/56

(54) **Anlage zur Beschichtung von Schraubenköpfen**

(30) Priorität: 27.09.1996 DE 29616846 U
(71) Anmelder: METAPLAS IONON Oberflächenveredelungstechnik GmbH, D-51427 Bergisch Gladbach (DE)
(72) Erfinder: Cremer, Dieter, 51491 Overath (DE)
(74) Vertreter: Stenger, Watzke & Ring Patentanwälte

(57) **Zusammenfassung**

Die Erfindung betrifft eine Anlage zur Beschichtung von Schraubenköpfen mit insbesondere aus einer Zinkoxydschicht bestehenden Ultraschallsensoren sowie mit weiteren Schichten in mehreren nacheinander zu durchlaufenden Behandlungskammern. Um eine derartige Anlage derart zu verbessern, daß die Anlage einfach, wartungsarm und regelungstechnisch unproblematisch zu betreiben ist, wird vorgeschlagen, drei identische, miteinander verbundene Behandlungskammern vorzusehen, in denen die Schraubenköpfe jeweils einer Beschichtungsart unterziehbar sind.

## Beschreibung

Die Erfindung betrifft eine Anlage zur Beschichtung von Schraubenköpfen mit insbesondere aus einer Zinkoxydschicht bestehenden Ultraschallsensoren sowie mit weiteren Schichten in mehreren nacheinander zu durchlaufenden Behandlungskammern.

In der Praxis hat sich herausgestellt, daß für viele Einsatzzwecke die Messung der exakten Vorspannkraft einer Schraubverbindung wichtiger ist als die Messung der Hilfsgröße Drehmoment. Der Einsatz unmittelbar vorspannkraftgesteuerter Schraubverfahren ist in der industriellen Montage bisher an den schwierigen und teuren Messungen der in der Verbindung wirkenden Kraft gescheitert, da die für Laborzwecke geeigneten Kraftmeßdosen nicht für die Serienproduktion geeignet sind. Zur Überwindung dieses Problems wurden mittlerweile Verfahren zur Messung der Längenänderung einer Schraube mittels Ultraschall entwickelt. Bei diesen neuen Verfahren zur Messung der Vorspannkraft wird ein Sensor auf den Schraubenkopf aufgedampft, welcher als Teil der Schraube eine direkte und kopplungsfreie Messung der Schraubenlänge erlaubt. Als geeignete Sensoren haben sich wenige Mikrometer dicke Zinkoxydschichten bewährt, deren piezoelektrische Eigenschaften zur Erzeugung des Ultraschallsignals und zum Empfang des Echos genutzt werden. Über dieser, den Ultraschallsensor bildenden Zinkoxydschicht liegen wenigstens zwei weitere Schichten, die eine Schutzschicht und eine Elektrode darstellen.

Die bekannten Anlagen zur Beschichtung von Schraubenköpfen mit Ultraschallsensoren arbeiten nach dem Prinzip von Durchlaufanlagen, bei denen die zu beschichtenden Werkstoffe die in Reihe hintereinander geschalteten und durch Schieberventile voneinander getrennten Behandlungskammern durchlaufen. Bei diesen bekannten Anlagen muß bei einem Schieber- oder Transportdefekt die gesamte Beladung aus dem System gefahren werden, was einen zeit- und kostenintensiven Stillstand der gesamten Anlage bei der Fehlfunktion nur eines Anlagenteils zur Folge hat. Darüber hinaus treten erhebliche regelungstechnische Probleme bei der Steuerung dieser in Reihe geschalteten Anlage auf.

Der Erfindung liegt die **Aufgabe** zugrunde, eine Anlage zur Beschichtung von Schraubenköpfen mit Ultraschallsensoren derart zu verbessern, daß die Anlage einfach, wartungsarm und regelungstechnisch unproblematisch zu betreiben ist.

Die technische **Lösung** dieser Aufgabe durch die Erfindung ist gekennzeichnet durch drei identische, nicht miteinander verbundene Behandlungskammern, in denen die Schraubenköpfe jeweils einer Beschichtungsart unterziehbar sind. Vorteilhaft bei diesem batchweisen Anlagenbetrieb im Vergleich zur Durchlauf-Reihenschaltung sind die mit bis zu 50 % Kostenersparnis deutlich geringere Anlagenkosten, eine höhere Betriebssicherheit, da unter anderem Schleusenschieber entfallen, sowie ein geringerer regelungstechnischer Aufwand, da die drei nicht miteinander verbundenen Behandlungskammern jeweils separat gesteuert und be- bzw. entladen werden können.

Gemäß einer bevorzugten Ausführungsform der Erfindung erfolgt in der ersten Behandlungskammer die Beschichtung mit den Zinkoxyd-Ultraschallsensoren, während in der zweiten Behandlungskammer eine CrON-Beschichtung und in der dritten Behandlungskammer eine Zn-Beschichtung erfolgt. Diese zusätzlichen Beschichtungen der Schraubenköpfe sind notwendig, um diese mit einer Schutzschicht und einer Elektrode zu versehen.

Der Transport der zu beschichtenden Werkstücke zwischen den einzelnen Behandlungskammern erfolgt vorteilhafterweise über eine Krananlage, mit welcher die einzelnen Behandlungskammern von oben beladen werden können.

Weiterhin wird mit der Erfindung vorgeschlagen, daß in mindestens einer Behandlungskammer die Behandlungsplätze im Kreis verfahrbar angeordnet sind, um eine gleichmäßige Beschichtung der Schraubenköpfe zu gewährleisten.

Weitere Einzelheiten und Merkmale der Erfindung ergeben sich aus der nachfolgenden Beschreibung der zugehörigen Zeichnung, in der eine erfindungsgemäße Anlage schematisch dargestellt ist.

Die dargestellte Anlage besteht aus drei separaten identischen Behandlungskammern 1, in die die zu behandelnden Schraubenköpfe an vorgegebene Behandlungsplätze 2 eingelegt werden. Die Beschichtung der Schraubenköpfe erfolgt durch Aufdampfen, sogenanntes Aufsputtern, über in den Behandlungskammern 1 angeordnete Sputtertargets 3. Bei dem dargestellten Ausführungsbeispiel sind in der Behandlungskammer 1 zum Aufdampfen der Zinkoxyd-Ultraschallsensoren acht Sputtertargets 3 angeordnet, während in den Behandlungskammern 1 zur Aufbringung der CrON-Beschichtung sowie der Zn-Beschichtung jeweils nur vier Sputtertargets 3 angeordnet sind. Die auf den Behandlungsplätzen 2 angeordneten Schraubenköpfe werden zumindest in den Behandlungskammern 1 zur Aufbringung der CrON- sowie der Zn-Beschichtungen, die mehr Behandlungsplätze 2 als Sputtertargets 3 enthalten, in Richtung der dargestellten Pfeile verfahren, damit alle Behandlungsplätze 2 vor den Sputtertargets 3 zu liegen kommen.

Die Befüllung der einzelnen Behandlungskammern 1 sowie der Transport der zu beschichtenden Schraubenköpfe von einer Behandlungskammer 1 zur nächsten Behandlungskammer 1 erfolgt von oben durch eine nicht dargestellte Krananlage.

Eine solchermaßen ausgestaltete Anlage zur Beschichtung von Schraubenköpfen zeichnet sich dadurch aus, daß alle Behandlungskammern 1 als separate und unabhängig voneinander arbeitende Kammern ausgebildet sind, wodurch eine rationelle und regelungstechnisch einfache Arbeitsweise ermöglicht wird.

### Bezugszeichenliste

- 1: Behandlungskammer
- 2: Behandlungsplatz
- 3: Sputtertarget

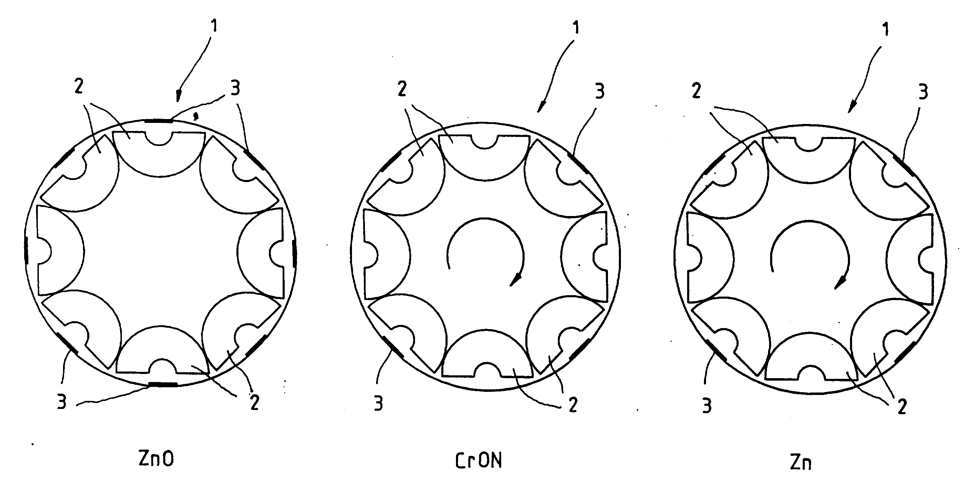

## Patentansprüche

1. Anlage zur Beschichtung von Schraubenköpfen mit insbesondere aus einer Zinkoxydschicht bestehenden Ultraschallsensoren sowie mit weiteren Schichten in mehreren nacheinander zu durchlaufenden Behandlungskammern (1),
**gekennzeichnet durch**
drei identische, nicht miteinander verbundene Behandlungskammern (1), in denen die Schraubenköpfe jeweils einer Beschichtungsart unterziehbar sind.

2. Anlage nach Anspruch 1, dadurch gekennzeichnet, daß in der ersten Behandlungskammer (1) die Beschichtung mit den Zinkoxyd-Ultraschallsensoren erfolgt, in der zweiten Behandlungskammer (1) eine CrON-Beschichtung und in der dritten Behandlungskammer (1) eine Cn-Beschichtung erfolgt.

3. Anlage nach Anspruch 1 oder 2, dadurch gekennzeichnet, daß der Transport der zu beschichtenden Schraubenköpfe zwischen den einzelnen Behandlungskammern (1) über eine Krananlage erfolgt.

4. Anlage nach einem der Ansprüche 1 bis 3, dadurch gekennzeichnet, daß in mindestens einer Behandlungskammer (1) im Kreis verfahrbare Behandlungsplätze (2) angeordnet sind.
